(19) Europäisches Patentamt / European Patent Office / Office européen des brevets

(11) **EP 2 396 447 B1**

(12) **FASCICULE DE BREVET EUROPEEN**

(45) Date de publication et mention de la délivrance du brevet:
**31.10.2018 Bulletin 2018/44**

(51) Int Cl.:
*C23C 14/58* *(2006.01)*    *B01J 37/34* *(2006.01)*
*C23F 4/02* *(2006.01)*    *B01J 23/42* *(2006.01)*
*B01J 23/52* *(2006.01)*    *B01J 23/72* *(2006.01)*
*B01J 23/745* *(2006.01)*    *B01J 23/755* *(2006.01)*
*B01J 35/00* *(2006.01)*    *C23F 4/00* *(2006.01)*

(21) Numéro de dépôt: **10708319.8**

(22) Date de dépôt: **10.02.2010**

(86) Numéro de dépôt international:
**PCT/FR2010/050219**

(87) Numéro de publication internationale:
**WO 2010/092297 (19.08.2010 Gazette 2010/33)**

(54) **PROCEDE DE TRAITEMENT PAR UN FAISCEAU D'IONS D'UNE COUCHE METALLIQUE DEPOSEE SUR UN SUBSTRAT ET SUBSTRAT OBTENU**

VERFAHREN ZUR IONENSTRAHLBEHANDLUNG EINER AUF EINEM SUBSTRAT ABGELAGERTEN METALLSCHICHT UND SUBSTRAT DAMIT ERHALTEN

METHOD FOR THE ION BEAM TREATMENT OF A METAL LAYER DEPOSITED ON A SUBSTRATE AND SUBSTRATE ATTAINED THEREBY

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **10.02.2009 FR 0950824**

(43) Date de publication de la demande:
**21.12.2011 Bulletin 2011/51**

(73) Titulaire: **Quertech**
**14000 Caen (FR)**

(72) Inventeurs:
• **BUSARDO, Denis**
  **F-14510 Gonneville/Mer (FR)**
• **GUERNALEC, Frédéric**
  **F-35340 Liffre (FR)**

(74) Mandataire: **Cabinet Plasseraud**
**66, rue de la Chaussée d'Antin**
**75440 Paris Cedex 09 (FR)**

(56) Documents cités:
WO-A-97/43042    WO-A-02/095085
WO-A-2006/078952    WO-A1-97/43042
WO-A1-02/095085    WO-A1-2006/078952
US-A- 4 364 969    US-A- 4 364 969

• YAMADA I ET AL: "Materials processing by gas cluster ion beams" MATERIALS SCIENCE AND ENGINEERING R: REPORTS, ELSEVIER SEQUOIA S.A., LAUSANNE, CH, vol. 34, no. 6, 30 octobre 2001 (2001-10-30), pages 231-295, XP004308527 ISSN: 0927-796X
• PANITZ J K G ET AL: "Conical surface textures formed by ion bombarding 2% Be-Cu alloy", JOURNAL OF MICROMECHANICS & MICROENGINEERING, INSTITUTE OF PHYSICS PUBLISHING, BRISTOL, GB, vol. 1, no. 1, 1 March 1991 (1991-03-01), pages 52-59, XP020069229, ISSN: 0960-1317, DOI: 10.1088/0960-1317/1/1/010
• YAMADA I ET AL: "Materials processing by gas cluster ion beams", MATERIALS SCIENCE AND ENGINEERING: R: REP, ELSEVIER, AMSTERDAM, NL, vol. 34, no. 6, 30 October 2001 (2001-10-30), pages 231-295, XP004308527, ISSN: 0927-796X, DOI: 10.1016/S0927-796X(01)00034-1

**Description**

L'invention a pour objet un procédé de traitement par un faisceau d'ions d'une couche métallique déposée sur un substrat et vise à permettre de produire des nanoparticules métalliques à partir de la couche métallique déposée sur le substrat.

On entend par « nanoparticule » un assemblage de quelques dizaines à quelques milliers d'atomes, conduisant à un objet dont au moins l'une des dimensions est de taille nanométrique, c'est-à-dire comprise entre 1 nm et 100 nm. Du point de vue dimensionnel, les nanoparticules se situent entre la matière dite macroscopique et l'échelle atomique ou moléculaire. On constate usuellement que les propriétés physico-chimiques de tels objets diffèrent sensiblement de celles qui prévalent à une plus grande échelle. De tels objets peuvent conduire à des applications très avantageuses, par exemple dans les domaines de la biologie et de la pharmacie, des matériaux et de la synthèse chimique, de la microélectronique notamment dans la perspective d'ordinateurs quantiques.

Il en résulte un besoin de méthode de production de nanoparticules, de préférence selon des méthodes facilement industrialisables, de manière à pouvoir offrir de telles nanoparticules en quantité significative et à des coûts raisonnables.

Dans l'art antérieure des différentes procédés pour texturiser les surfaces à base des faisceaux d'ions sont décrits, voir "Materials processing by gas cluster ion beams", I.Yamada, e.a., Mat.Sc.and Eng., R.34, 2001, pp231-295 et "Conical surface textures formed by ion bombarding 2%Be-Cu alloy", J.K.G. Pantiz, J.Micromech. Microeng., 1, 1991, pp.52-59.

L'invention a pour but d'offrir une méthode de production de nanoparticules peu onéreuse et permettant d'obtenir des quantités de nanopoudres répondant aux besoins de nombreuses applications.

L'invention propose ainsi un procédé de traitement par un faisceau d'ions d'une couche métallique déposée sur un substrat qui comprend une étape (a) de fragmentation de ladite couche métallique où :

- la couche métallique a une épaisseur, $e_{frag}$, comprise entre 0,2 nm à 20 nm (nanomètre) ;
- les ions du faisceau d'ions sont sélectionnés parmi les ions des éléments de la liste constituée de l'hélium (He), du bore (B), du carbone (C), de l'azote (N), de l'oxygène (0), du néon (Ne) ;
- la tension d'accélération des ions est comprise entre 20kV et 200kV
- la température de la couche métallique est inférieure ou égale à $T_f/3$, où $T_f$ est la température de fusion du métal de ladite couche métallique ;
- on choisit la dose d'ions par unité de surface dans une plage comprise entre $10^{12}$ ions/cm$^2$ et $10^{18}$ ions/cm$^2$ de manière à fragmenter la couche métallique pour produire des amas métalliques sous forme de nanoparticules sur la surface du substrat, dont l'épaisseur maximale est comprise entre 0,2 nm et 20 nm et la largeur maximale est comprise entre 0,2 nm et 100 nm.

Selon un mode de réalisation, la largeur maximale est inférieure ou égale à 20 nm.

Selon un mode de réalisation, l'épaisseur et la largeur maximales sont inférieures ou égales à 10 nm, voire inférieures ou égales à 5 nm.

Dans le cadre de la présente invention, on entend par « fragmentation » un procédé permettant de diviser une couche d'un matériau de manière à produire des amas dudit matériau de la couche, isolés les uns des autres. Les amas résultant de la couche ainsi fragmentés ne sont pas en continuité de matière les uns avec les autres. En conséquence ces amas sont présents sur la surface du substrat et sont séparés par des zones où ledit substrat est dépourvu de la matière de la couche, c'est-à-dire est dénudé.

On nomme « taux de couverture » le rapport entre la surface couverte par la matière de la couche après fragmentation rapportée à la surface du substrat.

Il résulte donc du procédé selon l'invention un substrat recouvert d'amas discontinus dont les dimensions correspondent à celles d'objets qualifiés usuellement de nanoparticules.

Selon un mode de réalisation, le taux de couverture est inférieur ou égal à 90% par exemple inférieur ou égal à 50%. Selon un mode de réalisation, le taux de couverture est compris entre 30% et 10%.

La surface du substrat présente entre les amas métalliques peut être identique à la surface initiale du substrat ; elle peut également avoir été partiellement abrasée par les ions, et/ou faire l'objet d'un réarrangement chimique, tel que par exemple lié à une implantation des ions du faisceau d'ions et/ou à une oxydation superficielle.

La couche métallique, d'épaisseur comprise entre 0,2 nm et 20 nm, peut être une couche continue ou une couche discontinue. On entend par « couche discontinue » une couche où les zones du substrat, recouvertes par le métal de ladite couche, ont une dimension surfacique d'au moins plusieurs nanomètres carré, de préférence d'au moins plusieurs milliers de nanomètres carré, voire supérieure ou égale au micromètre carré.

Dans le cadre de la présente invention, on entend par épaisseur d'un amas ou d'une couche, une dimension dans une direction perpendiculaire à la surface du substrat.

Dans le cadre de la présente invention, on entend par largeur d'un amas, une dimension dans un plan parallèle ou tangent au substrat.

La couche métallique à traiter selon l'étape (a) peut être obtenue par dépôt d'un métal sur un substrat à l'épaisseur désirée, $e_{frag}$, ou être obtenue après amincissement d'une couche de métal d'épaisseur supérieure à l'épaisseur $e_{frag}$ déposée sur le substrat. Parmi les techniques d'amincissement, on peut citer des techniques de polissage mécanique et/ou chimique, des techniques d'abrasion par jet de matière.

Le substrat peut être dense ou poreux.

La couche métallique déposée sur le substrat peut être obtenue par exemple par dépôt physique (par exemple PVD pour « *physical vapor déposition* », dépôt physique en phase vapeur), dépôt chimique gazeux (par exemple par CVD pour « *chemical vapor déposition* », dépôt chimique en phase vapeur), dépôt chimique en milieu liquide (par exemple par électrolyse). Dans le cas de substrat poreux, la couche métallique peut être déposée par imprégnation par un liquide contenant le métal à déposer ; à titre d'exemple, on peut utiliser de l'hydrogeno-hexachloroplatinate (IV) pour imprégner un substrat poreux, puis traiter le substrat imprégné à 500°C pendant plusieurs heures dans un flux d'air afin d'obtenir une couche de platine.

Le choix des ions et des conditions de bombardement de ces ions selon l'invention permet d'obtenir avantageusement des nanoparticules à la surface du substrat.

Les inventeurs ont pu constater que les plages choisies selon l'invention de tension d'accélération et de dose d'ions par unité de surface permettent de sélectionner des conditions expérimentales où la production de nanoparticules à partir d'une couche métallique déposée sur un substrat est possible grâce à un bombardement ionique.

En outre, ils ont pu constater que le procédé selon l'invention peut être mis en oeuvre « à froid », notamment à température ambiante et qu'il convient que la température de la couche métallique demeure inférieure ou égale à la valeur $T_f/3$ durant la mise en oeuvre du procédé. On peut ainsi éviter avantageusement que les nanoparticules formées n'aient tendance à coalescer et à former des amas dont la taille serait difficilement contrôlable.

Le choix de la dose d'ions par unité de surface dans la plage de dose selon l'invention peut résulter d'une étape préalable d'étalonnage où on bombarde avec un des ions parmi He, B, C, N, 0, Ne, un échantillon comprenant la couche de métal à traiter déposée sur un substrat. Le bombardement de cette couche de métal peut s'effectuer dans différentes zones de la couche avec une pluralité de doses d'ions, dans la plage selon l'invention, et on observe les zones traitées de manière à choisir une dose adéquate en fonction de la taille désirée des nanoparticules à produire.

L'observation des zones traitées ainsi peut s'effectuer par des techniques d'observation nanoscopiques, telles que microscopie à effet tunnel, microscopie à force atomique. Il est également possible d'utiliser des techniques d'analyse chimique de surface ou des techniques de physico-chimie pour caractériser les zones traitées, telles que par exemple des techniques d'adsorption ou de conversion de gaz.

Sans vouloir être lié par une quelconque théorie scientifique, on peut penser que le bombardement des ions dans les conditions selon l'invention fait l'effet d'un « hachoir » à l'échelle nanométrique grâce auquel les réarrangements atomiques permettent la genèse d'amas métalliques dont l'épaisseur maximale est comprise entre 0,2 nm et 20 nm et la largeur maximale est comprise entre 0,2 nm et 100 nm. On peut « régler » les dimensions des amas pour obtenir des caractéristiques souhaitées en faisant varier les paramètres du faisceau d'ions.

Selon différents modes de réalisation qui peuvent être combinés entre eux :

- la dose d'ions par unité de surface est comprise entre $10^{14}$ ions/cm$^2$ et $10^{17}$ ions/cm$^2$ ;
- l'épaisseur de la couche métallique, $e_{frag}$, est comprise entre 1 nm et 10 nm ;
- les ions sont produits par une source à résonance cyclotronique électronique (RCE) qui a l'avantage d'être compacte et économe en énergie.

Selon un mode de réalisation, le procédé selon l'invention comprend en outre une étape (aa) de pulvérisation de couche métallique, préalable à l'étape (a) de fragmentation de couche métallique, consistant à réduire l'épaisseur initiale, $e_{pulv} + e_{frag}$, d'une couche métallique déposée sur le substrat par bombardement ionique jusqu'à ce que ladite couche atteigne l'épaisseur $e_{frag}$. Cette étape (aa) permet avantageusement de diminuer l'épaisseur d'une couche métallique initiale, qui est supérieure à $e_{frag}$, avec le même dispositif que celui qui est mis en oeuvre pour l'étape (a) de fragmentation de la couche métallique d'épaisseur $e_{frag}$. On met pour cela à profit la capacité du bombardement ionique à pulvériser des atomes. De préférence on choisit des tensions d'accélération telles que seul le mécanisme de pulvérisation des atomes de surface de la couche métallique par les ions est mis en oeuvre. On cherche notamment à éviter que les ions bombardés puissent s'implanter.

Selon un mode de réalisation du procédé selon l'invention, l'étape (a) de fragmentation de la couche métallique est mise en oeuvre avec des ions légers, choisis parmi les ions des éléments de la liste constituée de l'hélium (He), du bore (B), du carbone (C), de l'azote (N), de l'oxygène (O), du néon (Ne). Le choix d'ions légers peut permettre un mécanisme de fragmentation avantageux.

Selon un mode de réalisation, l'étape du choix de la dose d'ions par unité de surface de manière à fragmenter la couche métallique pour produire des amas métalliques est effectuée en utilisant des données préalablement établies permettant de représenter l'évolution du taux de couverture d'une couche métallique en fonction de la dose d'ions par unité de surface. Ces données peuvent par exemple être basées sur des mesures expérimentales du taux de couverture d'une couche métallique obtenues par spectroscopie de photo électrons X (XPS).

Selon différents modes de réalisation du procédé selon la présente invention, qui peuvent être combinés entre eux :

- le substrat et la couche métallique sont mobiles par rapport au faisceau d'ions à une vitesse, $V_D$, comprise entre 0,1 mm/s et 1000 mm/s. Il est ainsi possible de déplacer l'échantillon pour traiter des zones dont la dimension est supérieure à celle du faisceau. La vitesse de défilement $V_D$, peut être constante ou variable. Selon un mode de réalisation, le substrat et la couche métallique se déplacent et le faisceau d'ions est fixe. Selon un autre mode de réalisation, le faisceau d'ions balaie la couche métallique à traiter. Il est également possible que le substrat et la couche métallique se déplacent quand le faisceau d'ions est mobile. Selon un mode de réalisation, une même zone de la couche métallique est déplacée sous le faisceau d'ions selon une pluralité, N, de passages à la vitesse $V_D$. Il est ainsi possible de traiter une même zone de la couche métallique avec une dose d'ions correspondant à la somme des doses d'ions reçues par cette zone à l'issue des N passages. On note également que si la taille de la couche métallique à traiter le permet, l'étape de fragmentation (a) peut être statique et résulter d'un ou plusieurs « flash » d'ions ;

- la couche métallique est constituée d'un métal ou d'un alliage de ce métal, où le métal est choisi parmi la liste constituée du fer (Fe), du cobalt (Co), du nickel (Ni), du cuivre (Cu), du ruthénium (Ru), du rhodium (Rh), du palladium (Pd), de l'argent (Ag), du cérium (Ce), de l'osmium (Os), de l'iridium (Ir), du platine (Pt), de l'or (Au) ;

- le substrat est constitué d'un matériau choisi parmi la liste constituée des céramiques, des verres, des semiconducteurs, des métaux, des polymères. Parmi les céramiques susceptibles d'être utilisées comme substrat, on peut citer, de manière non limitative, les oxydes d'aluminium ($Al_2O_3$), d'hafnium ($HfO_2$), de zirconium ($ZrO_2$), de silicium ($SiO_2$) ; le substrat peut également être en graphite (C) ou en silicium (Si) ; si le substrat est métallique, celui-ci est constitué de préférence d'un métal de nature différente de celui de la couche métallique à traiter ; à titre d'exemple, le substrat est métallique et en acier inoxydable, par exemple sous la forme de plaque ou de feuillard ; selon un mode de réalisation, le substrat est un polymère, par exemple sous forme de plaque ou de film, et on utilise le bombardement ionique pour post-réticuler ledit polymère et notamment le durcir ;

- le substrat est constitué d'un matériau sous forme de poudres et le traitement par un faisceau d'ions est mis en oeuvre avec un vide primaire laminé ; il est ainsi possible de traiter des poudres recouvertes d'une couche métallique, obtenue par exemple par imprégnation ; à titre d'exemples, les poudres formant substrat sont des poudres d'alumine ou des zéolithes. On entend par « vide primaire laminé » un vide primaire obtenu en réduisant fortement la descente en vide par rapport à une descente en vide conventionnelle, de manière à éviter toute turbulence à l'intérieur de l'enceinte qui pourrait provoquer l'aspiration des poudres. A cette fin, on procède dans des conditions où la conductance entre l'enceinte et la pompe est réduite en mettant par exemple des séries de lames devant la pompe primaire.

L'invention vise également un substrat recouvert d'amas métalliques sous forme de nanoparticules sur la surface du substrat dont l'épaisseur maximale est comprise entre 0,2 nm et 20 nm et la largeur maximale est comprise entre 0,2 nm et 100 nm, obtenu selon un des modes de réalisation du procédé de la présente invention, où lesdits amas métalliques occupent entre 1% et 90% de la surface du substrat et où le substrat est dénudé sur respectivement 99% à 10% de sa surface.

La quantité d'amas métalliques peut dépendre par exemple de l'utilisation souhaitée. On peut en effet concevoir des substrats recouverts de très peu (de l'ordre de quelques pourcents de leur surface) d'amas métalliques, où ces amas métalliques sont très réactifs par rapport à l'application visée. Pour d'autres applications, on peut souhaiter obtenir un recouvrement très important du substrat, par exemple de plus de 70% de sa surface, c'est-à-dire avec un taux de couverture de plus de 70% pour multiplier les sites réactifs. On constate que pour de nombreuses applications, comme par exemple des applications en catalyse, un recouvrement correspondant à un taux de couverture de 10% à 60% de la surface du substrat par des amas métalliques permet d'obtenir des résultats satisfaisants. Selon un mode de réalisation, le taux de couverture pour des applications en catalyse est de 10% à 30% ; selon un autre mode de réalisation, le taux de couverture pour des applications en catalyse est de 30% à 60%.

L'invention porte également sur un dispositif de catalyse hétérogène comprenant une zone de transformation d'un gaz ou d'un liquide comprenant au moins un substrat recouvert d'amas métalliques selon la présente invention.

Selon un mode de réalisation, le dispositif de catalyseur hétérogène est un pot catalytique, visant à limiter la nocivité des gaz d'échappement de véhicules motorisés. On obtient ainsi des catalyseurs d'oxydation à réactivité améliorée à basse température.

Les substrats recouverts d'amas métalliques selon l'invention peuvent être utilisés dans de nombreux autres domaines techniques, tels que par exemple ceux relatifs aux piles à combustible, au traitement du pétrole ou des produits pétroliers, tels que par exemple raffinage, désulfuration.

D'autres particularités et avantages de la présente invention ressortiront dans la description ci-après d'exemples de réalisation non limitatifs, notamment en référence aux dessins annexés dans lesquels :

- les figures la à 1c illustrent différentes étapes d'un exemple d'un procédé selon l'invention ;

- les figures 2a à 2c illustrent la surface d'échantillons, notamment traités selon l'invention ;

- la figure 3 illustre la variation du rapport Pt/Si en fonction de la dose reçue par un échantillon ;

- les figures 4, 5a et 5b illustrent des spectres XPS de surface d'échantillons, notamment traités selon l'invention.

- les figures 6 à 9 représentent des exemples d'évolution du taux de couverture, S, en ordonnée, en fonction de doses d'ions par unité de surface pour des couches métalliques et des ions donnés.

Pour des raisons de clarté, les dimensions des différents éléments représentés sur ces figures ne sont pas nécessairement en proportion avec leurs dimensions réelles. Les mêmes références numériques sur les différentes figures correspondent aux mêmes parties.

Les figures la à 1c illustrent différentes étapes d'un exemple de mise en oeuvre du procédé selon l'invention.

Une couche métallique, par exemple de platine 10, 20 est déposée sur un substrat 30, par exemple en silicium, tel qu'illustré en figure la.

La couche métallique est continue et son épaisseur initiale vaut $e_{pulv} + e_{frag}$, par exemple de l'ordre de quelques dizaines de nanomètres, voire de l'ordre de micromètre. Un faisceau d'ions 100 balaie la surface de la couche métallique, par exemple d'abord dans le sens de la flèche 150, puis dans le sens de la flèche opposée, de manière à ce qu'une même zone de la surface de la couche métallique voie plusieurs passages du faisceau d'ions.

Pendant une première étape (aa), les ions du faisceau 100 sont choisis et leur tension d'accélération est réglée de manière à pulvériser une partie 20 de la surface métallique afin de réduire cette dernière à une épaisseur $e_{frag}$, comprise entre 0,2nm et 20 nm.

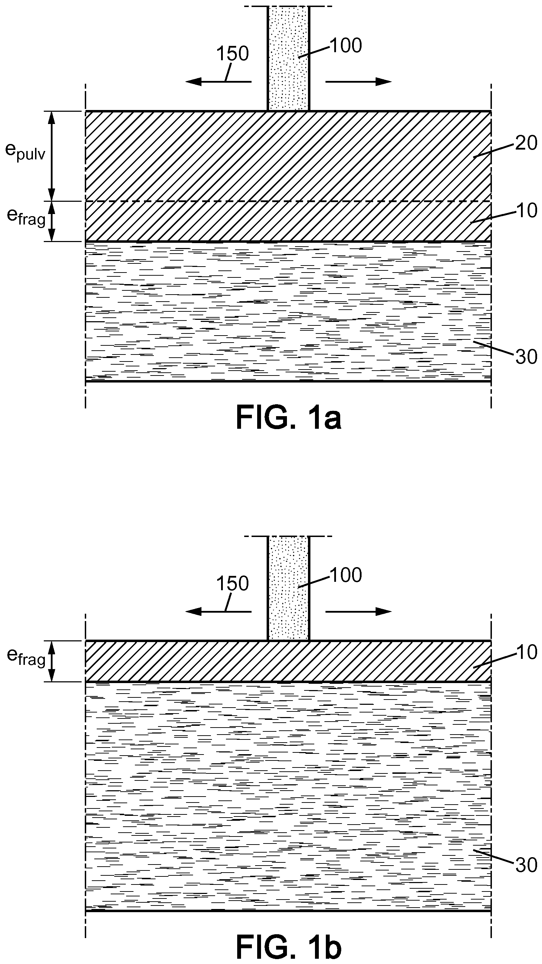

Après réduction de la couche métallique initiale à l'épaisseur $e_{frag}$ désirée, on procède à une étape de fragmentation illustrée en figure 1b.

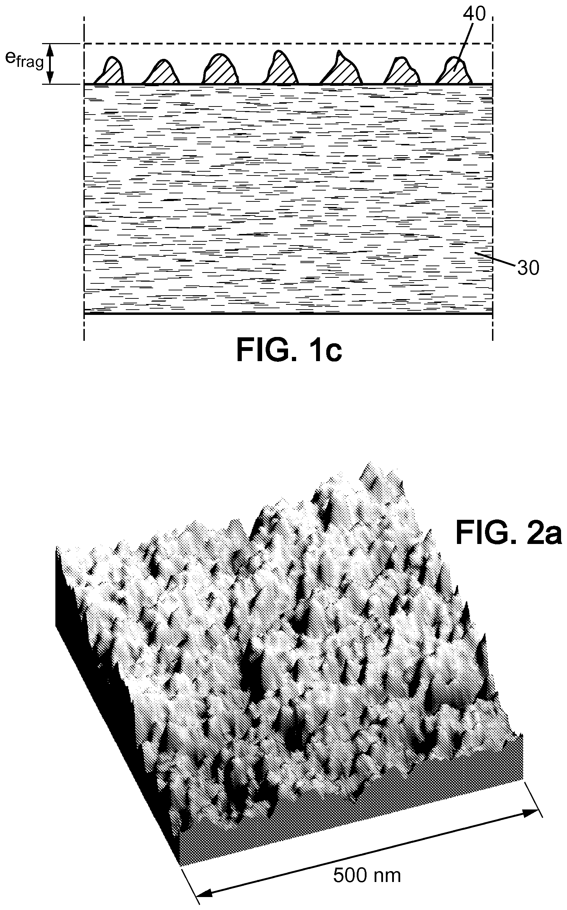

Les ions du faisceau 100 peuvent être identiques à ceux utilisés pour l'étape précédente, ou on peut choisir des ions lourds pour l'étape précédente (aa) et des ions légers pour la présente étape (a) de pulvérisation. Leur tension d'accélération et la dose d'ions par unité de surface sont choisis pour fragmenter la couche métallique 10 afin de produire des amas métalliques 40 dont l'épaisseur maximale est comprise entre 0,2 nm et 20 nm et la largeur maximale comprise entre 0,2 nm et 100 nm, tel qu'illustré en figure 1c.

Selon des exemples de mise en oeuvre de la présente invention des échantillons où des couches métalliques de platine (Pt), cuivre (Cu), nickel (Ni), fer (Fe) de 10 nm déposées sur un substrat en silicium ont fait l'objet d'études pour un traitement avec des ions d'azote émis par une source RCE.

Le faisceau d'ions comprend des ions $N^+$ dont l'intensité est sensiblement 20 $\mu$A et $N^{2+}$ dont l'intensité est sensiblement 20 $\mu$A ; la tension d'extraction et d'accélération est de 45 kV ; l'énergie de $N^+$ est de 45 keV et celle de $N^{2+}$ de 90 keV.

Le faisceau a sensiblement une forme carrée de 2 mm de côté ; l'échantillon à traiter se déplace à 40 mm/s avec un pas d'avancement latéral à chaque retour de 1 mm.

Les tableaux 1 à 3 reportent les résultats avec une couche de Pt (tableau 1), une couche de Cu ou une couche de Ni (tableau 2), une couche de Fe (tableau 3).

Les résultats avec une couche de platine résultent d'essais et d'observations. On détermine la texturation de la couche métallique après les essais.

Les résultats avec une couche de Cu, ou de Ni, ou de Fe résultent d'essais préliminaires et d'extrapolations.

Tableau 1

| Nb de passes | Doses estimées ($10^{14}$ ions/cm$^2$) | Epaisseur pulvérisée estimée (nm) | Etat de la couche de Pt |
|---|---|---|---|
| 1 | 5,2 | 0,11 | Continue/lisse |

(suite)

| Nb de passes | Doses estimées ($10^{14}$ ions/cm$^2$) | Epaisseur pulvérisée estimée (nm) | Etat de la couche de Pt |
|---|---|---|---|
| 10 | 51,5 | 1,1 | Continue/lisse |
| 40 | 206 | 4,4 | Continue/déchiquetée |
| 50 | 257 | 5,5 | Fragmentée/dispersée ; nanocristaux de platine |
| 60 | 309 | 6,6 | Dispersée |
| 70 | 360 | 7,7 | Fortement dispersée |
| 100 | 515 | 11 | Aucune couche de platine |

Tableau 2

| Nb de passes | Doses estimées ($10^{14}$ ions/cm$^2$) | Epaisseur pulvérisée estimée (nm) | Etat de la couche de Cu ou de Ni |
|---|---|---|---|
| 1 | 5,2 | 0,078 | Continue/lisse |
| 10 | 51,5 | 0,78 | Continue/lisse |
| 40 | 206 | 3,12 | Continue/lisse |
| 50 | 257 | 3,9 | Continue/lisse |
| 60 | 309 | 4,68 | Continue/déchiquetée |
| 70 | 360 | 5,46 | Fragmentée/dispersée ; nanocristaux de cuivre ou de nickel |
| 80 | 412 | 6,24 | Dispersée |
| 90 | 463 | 7,02 | Fortement dispersée |
| 120 | 618 | 9,36 | Aucune couche de cuivre ou de nickel |

Tableau 3

| Nb de passes | Doses estimées ($10^{14}$ ions/cm$^2$) | Epaisseur pulvérisée estimée (nm) | Etat de la couche de Fe |
|---|---|---|---|
| 1 | 5,2 | 0,054 | Continue/lisse |
| 10 | 51,5 | 0,54 | Continue/lisse |
| 20 | 103 | 1,08 | Continue/lisse |
| 30 | 154 | 1,62 | Continue/lisse |
| 40 | 206 | 2,16 | Continue/lisse |
| 80 | 412 | 4,32 | Continue/déchiquetée |
| 100 | 515 | 5,4 | Fragmentée/dispersée ; nanocristaux de fer |
| 120 | 618 | 6,48 | Dispersée |
| 150 | 772 | 8,1 | Aucune couche de fer |

On constate que dans les conditions de faisceau et d'épaisseur initiale de la couche métallique mentionnées, on peut générer des nanocristaux de platine pour des doses de l'ordre de 2 à $3.10^{16}$ ions / cm$^2$, de cuivre ou de nickel pour des doses de 3 à $4.10^{16}$ ions/cm$^2$, pour le fer de 4 à $6.10^{16}$ ions/cm$^2$. Comme mentionné sur les différents tableaux, une partie des atomes de la couche métallique sont pulvérisés au cours du traitement de fragmentation.

Des observations de la surface d'échantillons de couches de platine déposée sur un substrat de silicium et traitées dans les conditions ci-dessus ont été effectuées par microscopie par force atomique (AFM pour « *atomic force microscopy* ») et par spectroscopie de photoélectrons X (XPS pour « *X-ray photo electron spectroscopy* » également nommé ESCA pour « *electron spectroscopy for chemical analysis* »).

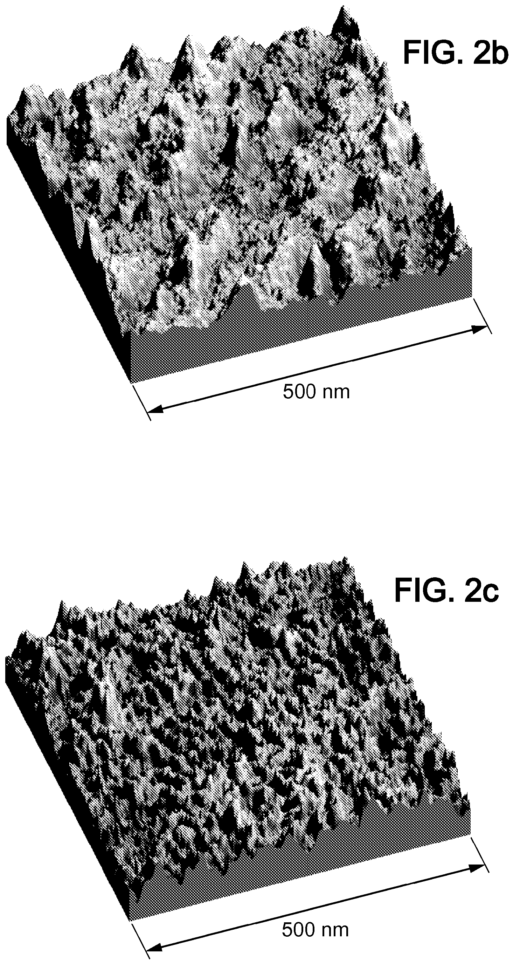

Les figures 2a, 2b, 2c représentent l'observation par AFM d'une zone de la couche de platine sur le substrat de silicium après respectivement 0 passe (avant traitement), 50 passes (soit une dose de l'ordre de $2.5.10^{16}$ ions/cm$^2$), 100 passes (soit une dose de l'ordre de $5.10^{16}$ ions/cm$^2$). La zone représentée correspond à une zone carrée de 500 nm de côté. La différence maximale de hauteur entre pics et vallées et de l'ordre de 20 nm en figure 2a, de l'ordre de 2nm en figures 2b et 2c.

On constate que la couche de platine est continue en figure 2a ; la couche de platine a été fragmentée et apparaît en figure 2b sous la forme d'amas dont l'épaisseur est de l'ordre de 2 nm et la largeur est de l'ordre de 20 à 50 nm ; ces amas sont séparés par des zones où le substrat de silicium a été découvert ; la couche de platine a disparu après 100 passes et on observe en figure 2c le substrat de silicium.

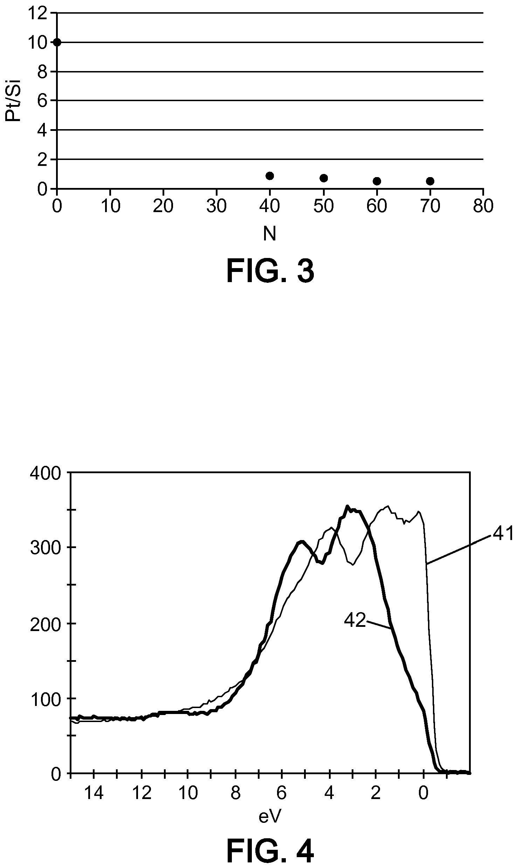

La figure 3 représente la variation du rapport de concentration atomique Pt/Si (en ordonnée) mesuré par XPS en fonction du nombre de passage, N, sous le faisceau, c'est-à-dire de la dose.

Le tableau 4 synthétise ces résultats et présente également le rapport Pt/ (Pt + Si), ainsi que le pourcentage atomique d'oxygène mesuré.

Tableau 4

| Nombre de passages | Pt/Si | Pt / (Si + Pt) | O (%) |
|---|---|---|---|
| 0 | 9,9 | 91 % | 17 |
| 40 | 0,84 | 46 % | 32 |
| 50 | 0,72 | 42 % | 34 |
| 60 | 0,47 | 32 % | 32 |
| 70 | 0,50 | 33 % | 27 |

On constate qu'un peu de Si est détecté à 0 passage, correspondant probablement soit à quelques zones du substrat non recouvertes de platine, soit à l'émission du Si du substrat sous la couche de platine.

La quantité de platine a diminué de manière très significative après 40 passages et on peut estimer qu'environ 40 à 50 % de la surface du substrat reste recouverte par du platine et que le silicium et mis à nu sur le reste de la surface. Cette observation est étayée par le fait qu'on observe simultanément à la diminution de la quantité de platine une augmentation du taux d'oxygène. On attribue cette augmentation à une oxydation du silicium du substrat après qu'il ait été mis à nu, confirmant ainsi que les amas de platine sont entourés de zones de substrat dépourvues de platine.

La figure 4 reporte des résultats de mesure d'XPS dans le domaine d'énergie de liaison compris entre 0 et 15 eV (en abscisse) où l'on porte le nombre de coups par seconde mesurés (en ordonnée) pour un échantillon avec 0 passage (courbe 41) et après 50 passages (courbe 42). On constate un décalage des pics en énergie qui signe une modification de la texturation de la couche de platine sous l'effet du bombardement ionique.

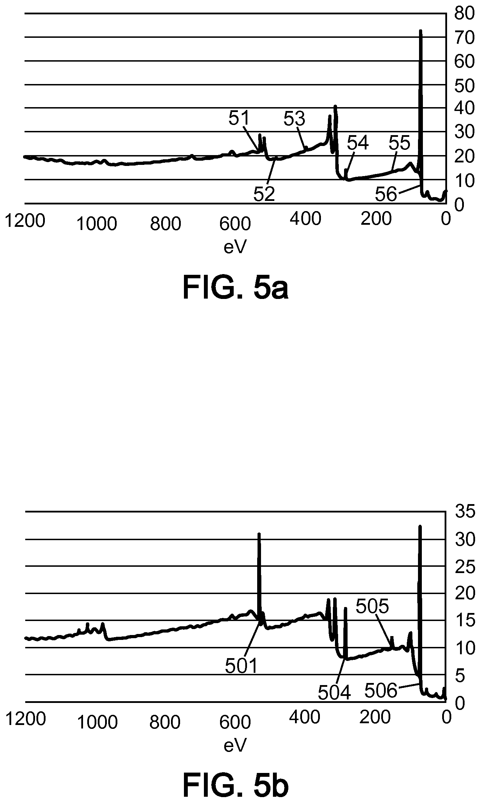

Les figures 5a et 5b illustrent des spectres XPS sur le domaine d'énergie de liaison compris entre 0 et 1200 eV (en abscisse) où l'on porte le nombre de coups (en milliers de coups par seconde, en ordonnée) pour un échantillon avec 0 passage (figure 5a) et après 70 passages (figure 5b). Les pics dont on suit particulièrement l'évolution sont les pics correspondant à O1s (51, 501), Sn2p3 (52), N1s (53), C1s (54, 504), Si2s (55, 505), Pt4f (56, 506). On confirme ainsi la forte augmentation de Si2s signant la mise à nu du substrat après 70 passages.

Des échantillons obtenus à partir d'une couche de platine sur un substrat de silicium et traités selon l'invention ont fait l'objet d'essais de catalyse. Un gaz contenant du CO a été envoyé entre 200 et 250°C sur un substrat recouvert de platine, après bombardement ionique et l'oxydation du CO a été constatée démontrant l'activité catalytique des échantillons. Cette activité disparaît après 100 passages dans les conditions ci-dessus.

Par ailleurs des échantillons comprenant des amas de platine (de 1 à 10 nm$^3$), finement dispersés et déposés sur un élément de monolithe en alumine poreuse ont également été traités selon l'invention. On a constaté que la fragmentation des amas de platine initiaux pour former des amas de plus petite taille et plus nombreux, peut être obtenue pour des doses comprises entre $10^{13}$ et $10^{14}$ ion/cm$^2$ d'azote à une énergie moyenne de 60 keV. Des essais d'oxydation du méthane CH$_4$ ont été effectués. On détermine expérimentalement la température $T_{50\%}$, à laquelle on obtient 50% de conversion du CH$_4$ en présence de différents catalyseurs, les autres conditions de mesure étant identiques. On constate que cette température baisse de 20°C environ pour un catalyseur constitué par les amas de platine fragmentés selon l'invention (T$_{50\%}$ environ 580°c), en comparaison à un catalyseur constitué des amas initiaux de 1 à 10 nm$^3$ (T$_{50\%}$ environ 600°C).

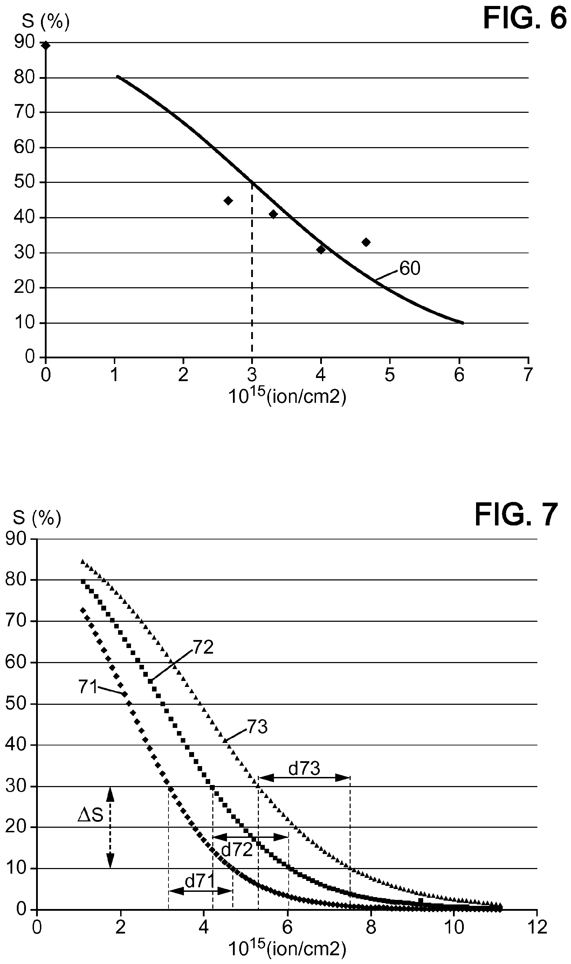

Les figures 6 à 9 représentent des exemples d'évolution du taux de couverture, S, exprimé en % en fonction de doses d'ions exprimés en 10$^{15}$ ion/ cm$^2$.

Ces figures et les enseignements qui en sont tirés permettent d'illustrer un mode de réalisation de l'étape du choix de la dose d'ions par unité de surface de manière à fragmenter une couche métallique pour produire des amas métalliques selon l'invention.

Selon ce mode de réalisation, on détermine expérimentalement l'évolution du taux de couverture d'une couche métallique donnée (métal donné, épaisseur donnée) en fonction de la dose d'ions d'un type donné d'ion pour une énergie donnée et on établit des relations permettant de transcrire l'enseignement obtenu de cette étude expérimentale pour déterminer le taux de couverture qui serait obtenu avec d'autres couches métalliques et/ou d'autres ions et/ou d'autres énergies des ions.

La figure 6 représente des mesures de taux de couverture effectuées sur une couche de platine d'épaisseur initiale de 10 nm déposée sur un substrat de silicium. Les ions utilisés sont des ions d'azote, à deux états de charge, N$^+$ et N$^{2+}$, produits par une source RCE. La tension d'accélération de ces ions est de 40 kV. On obtient donc des ions de 40 keV et 80 keV et on peut estimer que l'énergie moyenne de ces ions est de 60 keV.

La mesure du taux de couverture est effectuée par métrologie de spectroscopie de photo électrons X (XPS) sur une pluralité d'échantillons de la couche de Pt mentionnée après bombardement par différentes doses des ions mentionnés.

Les losanges portés sur la figure 6 correspondent aux points expérimentaux et la courbe 60 correspond à une courbe d'interpolation. Dans cet exemple on constate que le taux de couverture de la couche de Pt est initialement de l'ordre de 90% (échantillon de départ, avant bombardement ionique), que le taux de couverture est d'environ 50% pour environ 3.10$^{15}$ ion/cm$^2$, d'environ 10% pour environ 6.10$^{15}$ ion/cm$_2$.

Les points expérimentaux sont exploités en faisant l'hypothèse que la forme de la courbe 60 représentant le taux de couverture en fonction de la dose répond à une courbe statistique de type Fermi-Dirac. Les inventeurs ont développé un modèle d'extrapolation permettant de déduire d'une telle courbe des paramètres utiles pour effectuer des prédictions de courbes représentant le taux de couverture en fonction de la dose pour des conditions différentes de celles dans lesquelles une courbe de référence a été obtenue.

La courbe 60 représente la courbe de référence obtenue à partir des données expérimentales de la figure 6, pour une couche de Pt de 10 nm bombardée avec des ions d'azote d'énergie moyenne de 60 keV.

Grâce au modèle développé par les inventeurs, on peut extraire de cette courbe de référence 60 plusieurs données prédictives.

Selon l'hypothèse retenue, la variation du taux de couverture S en fonction de la dose d répond à l'équation suivante :

$$S(d) = 1/ [1 + exp(4.a (d-d_{50}))] \; ,$$

où :

    d est la dose d'ions ;
    d$_{50}$ est la dose correspondant à un taux de couverture de 50% ;
    a est la pente de la courbe 60 au point
    correspondant à un taux de couverture à 50%.

On établit que d$_{50}$ = e.s/V,
où :

    e est l'épaisseur initiale de la couche métallique ;
    s est la surface de l'impact ;
    V est le volume de l'impact ;

(e, s, V étant exprimés dans la même unité dimensionnelle, par exemple en nm).

On établit également que s = 2.a et V = e.10$^{14}$/d$_{50}$,
où :

    V est exprimé en nm3, e en nm ;
    d$_{50}$ en 10$^{15}$ ion /cm$^2$.

De l'exemple représenté en figure 6 on déduit que pour une couche de 10 nm de Pt bombardée par des ions de 60 keV d'énergie moyenne on a :
V = 0.33 nm$^3$ et s = 0,35 nm$^2$.

On constate des équations ci-dessus, qu'il est simple de prévoir la variation du taux de couverture en fonction de l'épaisseur initiale, e, une couche métallique d'un type donné dans des conditions de bombardement ionique où les paramètres s et V ont été déterminés.

En considérant que ces paramètres ont été déterminés pour une épaisseur $e_1$, on a pour une couche métallique du même type d'épaisseur $e_2$ :

$$S\ (d,\ pour\ e_2)\ =\ 1/\ [1\ +\ exp\ (2.s(d-e_2.s/V))]$$

A partir des données ci-dessus, les inventeurs ont montré qu'il est possible de prédire l'évolution du taux de couverture en fonction de la dose d'ions dans des conditions différentes de celles correspondant aux conditions expérimentales de la figure 6 en mettant en oeuvre une méthode de calcul fondée sur des estimations de taux de pulvérisation pour un métal donné, un ion incident donné, d'énergie donnée. On définit le « taux de pulvérisation » , p, comme le nombre d'atome extrait pour un ion incident.

Le calcul fondé sur des estimations de taux de pulvérisation pour un métal donné, un ion incident donné, d'énergie donnée se fonde sur les principes de la physique des interactions des particules avec la matière. Des méthodes et données permettant de faire ces calculs sont notamment divulguées dans les publications « The Stopping and Range of Ions in Matter » by J.F. Ziegler, volumes 2-6, Pergamon Press, 1977-1985, « The Stopping and Range of Ions in Solids » by J.F. Ziegler, J.P. Biersack and U. Littmark, Pergamon Press, New York, 1985 (new édition in 2009) et J.P. Biersack and L. Haggmark, Nucl. Instr. and Meth., vol. 174, 257, 1980.

En outre, des logiciels ont été développés et commercialisés afin de faciliter ou d'effectuer de tels calculs, comme par exemple les logiciels commercialisés sous les noms « SRIM » (« *The Stopping and Range of Ions in Matter* ») et « TRIM » (« *The Transport of Ions in Matter* »), développés notamment par James F. Ziegler.

Les estimations ainsi obtenues de taux de pulvérisation, p, du platine par un ion incident donné (He, N, Ar*) à différentes énergies moyennes (20, 60 et 100 keV) sont reportées ci-dessous dans le tableau 5 (* pas selon l'invention).

Tableau 5

| Ions incidents | P Pour 20 keV | P Pour 60 keV | P Pour 100 keV |
|---|---|---|---|
| He | 0,64 | 0,29 | 0,18 |
| N | 0,94 | 0,69 | 0,53 |
| Ar* | 4,24 | 4,41 | 4,14 |

Il est également possible d'obtenir des estimations de taux de pulvérisation, p, de différents métaux pour un même type d'ion incident. Les résultats pour Au, Pt, Fe pour des ions d'azote de différentes énergies moyennes sont reportées ci-dessous dans le tableau 6.

Tableau 6

| métal | P Pour 20 keV | P Pour 60 keV | P Pour 100 keV |
|---|---|---|---|
| Au | 2,60 | 1,20 | 1,10 |
| Pt | 0,94 | 0,69 | 0,53 |
| Fe | 1,62 | 0,70 | 0,51 |

On peut ensuite estimer les nouveaux paramètres s et V pour tout type d'ion, d'énergie correspondante et pour différents métaux de le cible. Pour cela on considère que le volume de l'impact V est proportionnel au taux de pulvérisation p et que la surface de l'impact est proportionnelle à $p^{2/3}$. Connaissant le volume de l'impact et la surface de l'impact extraits de la courbe de référence 60 ainsi que les taux de pulvérisation relatifs aux conditions de la courbe 60 et celles envisagées pour un nouveau type d'ion, une nouvelle énergie, dans un nouveau métal cible, on peut proportionnellement déduire le nouveau volume d'impact et la nouvelle surface d'impact.

Sur cette base on peut par exemple estimer l'évolution du taux de couverture pour une couche de platine du type étudié en figure 6 (10 nm d'épaisseur) en fonction de l'énergie moyenne des ions d'azote utilisés pour le bombardement. On porte en figure 7 les taux de couverture ainsi déterminés pour des ions d'azote d'énergie moyenne de 20 keV (courbe 71), des ions d'azote d'énergie moyenne de 60 keV (courbe 72, identique à la courbe de référence 60), des ions d'azote d'énergie moyenne de 100 keV (courbe 73).

Les calculs ont permis de déterminer les paramètres suivants, reportés dans le tableau 7.

Tableau 7

| Energie moyenne azote incident | $d_{50}$ (en $10^{15}$ ion/cm$^2$) | V (nm$^3$) | s (nm$^2$) |
|---|---|---|---|
| 20 keV | 2,20 | 0,45 | 0,44 |
| 60 keV | 3,00 | 0,33 | 0,36 |
| 100 keV | 3,9 | 0,25 | 0,30 |

En faisant l'hypothèse qu'un domaine de fragmentation désiré s'obtient pour un taux de couverture compris entre 10% et 30%, représenté par la plage $\Delta$S sur la figure 7, on peut estimer ainsi la dose d'ion à utiliser pour obtenir un tel résultat :

pour N à 20 keV, la plage de dose correspondante, $d_{71}$, se situe entre environ 3 et $5.10^{15}$ ion/cm$^2$ ;

pour N à 60 keV, la plage de dose correspondante, $d_{72}$, se situe entre environ 4 et $6.10^{15}$ ion/cm$^2$ ;

pour N à 100 keV, la plage de dose correspondante, $d_{73}$, se situe entre environ 5 et $8.10^{15}$ ion/cm$^2$.

On constate que plus l'énergie des ions d'azote incident augmente, plus il convient d'augmenter la dose d'ions pour obtenir la fragmentation souhaitée.

Selon un autre exemple, on peut estimer l'évolution du taux de couverture en fonction du type d'ion, pour une même énergie moyenne et la couche de platine de 10 nm d'épaisseur précédemment étudiée.

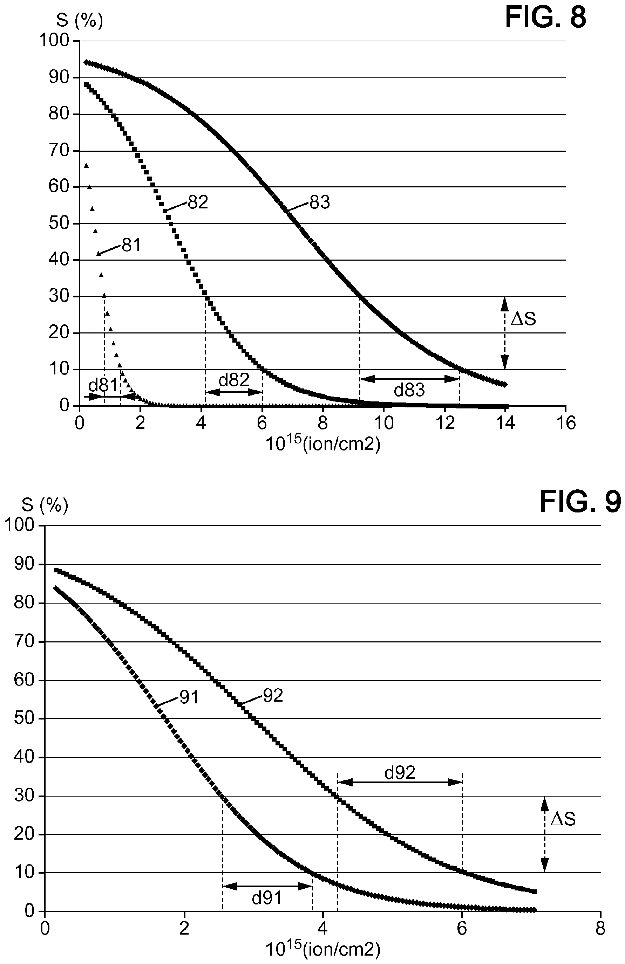

On porte en figure 8 les taux de couverture ainsi déterminés pour des ions d'Argon (Ar) en courbe 81, pour des ions d'azote (N) en courbe 82 (courbe identique aux courbes 60 et 72), pour des ions d'Hélium (He) en courbe 83, dans le cas où ces ions ont une énergie moyenne de 60 keV.

Les calculs ont permis de déterminer les paramètres suivants, reportés dans le tableau 8.

Tableau 8

| Ions incidents (à 60 keV) | $d_{50}$ (en $10^{15}$ ion/cm$^2$) | V (nm$^3$) | s (nm$^2$) |
|---|---|---|---|
| Ar | 0,46 | 2,13 | 1,23 |
| N | 3,00 | 0,33 | 0,36 |
| He | 7,13 | 0,14 | 0,20 |

En faisant la même hypothèse que précédemment pour déterminer la plage de dose d'ion à utiliser pour obtenir la fragmentation désirée, on obtient :

pour Ar, la plage de dose correspondant, $d_{81}$, se situe entre environ 1 et $1.5.10^{15}$ ion/cm$^2$ ;

pour N, la plage de dose correspondant, $d_{82}$, se situe entre environ 4 et $6.10^{15}$ ion/cm$^2$ ;

pour He, la plage de dose correspondant, $d_{83}$, se situe entre environ 9 et $13.10^{15}$ ion/cm$^2$.

Selon un autre exemple encore, il est possible d'estimer l'évolution du taux de couverture pour des couches de différents métaux, de même épaisseur (10 nm) bombardés avec des ions d'azote de 60 keV.

On porte en figure 9 les taux de couverture, déterminés grâce aux données du tableau 6, pour des couches métalliques d'or en courbe 91 et de platine ou de fer en courbe 92 (identique aux courbes 60, 71, 82).

En considérant les conditions établies précédemment, on détermine la plage de dose d'ion désirée pour l'or entre environ 3 et $4.10^{15}$ ion/cm$^2$ et pour le platine ou le fer entre environ 4 et $6.10^{15}$ ion/cm$^2$.

Il va de soi qu'il est possible de combiner les calculs et résultats exposés de manière à déterminer les doses désirées pour procéder à une fragmentation souhaitée pour les combinaisons possibles, notamment de type de métal de la couche, d'épaisseur de la couche, de type d'ion pour le traitement, de l'énergie de ces ions.

Il est ainsi possible de procéder au choix de la dose d'ions par unité de surface de manière à fragmenter la couche métallique de manière prédictive.

Il convient de noter que des observations expérimentales sur des échantillons ayant fait l'objet d'un traitement par un faisceau d'ion peuvent permettre de confirmer ou d'ajuster la plage de dose d'ions sélectionnée. De telles observations peuvent notamment être effectuées par XPS.

L'invention n'est pas limitée aux types de réalisation exemplifiés et doit être interprétée de façon non limitative et englobe tout mode de réalisation équivalent. Il convient de noter que si des exemples de mise en oeuvre avec des couches métalliques de Pt, Cu, Ni, Fe, ont été présentés, le procédé selon l'invention peut être mis en oeuvre avec de très nombreux métaux en vue d'obtenir des amas métalliques de taille nanoscopique.

## Revendications

1. Procédé de traitement par un faisceau d'ions (100) d'une couche métallique (10) déposée sur un substrat (30) **caractérisé en ce qu'**il comprend une étape (a) de fragmentation de ladite couche métallique où on entend par « fragmentation » un procédé permettant de diviser une couche d'un matériau de manière à produire des amas dudit matériau de la couche, isolés les uns des autres, ces amas étant présents sur la surface du substrat et étant séparés par des zones où ledit substrat est dépourvu de la matière de ladite couche et où:

   - la couche métallique (10) a une épaisseur, $e_{frag}$, comprise entre 0,2 nm à 20 nm (nanomètre) ;
   - les ions du faisceau d'ions sont sélectionnés parmi les ions des éléments de la liste constituée de l'hélium (He), du bore (B), du carbone (C), de l'azote (N), de l'oxygène (O), du néon (Ne) ;
   - la tension d'accélération des ions est comprise entre 20 kV et 200 kV;
   - la température de la couche métallique (10) est inférieure ou égale à $T_f/3$, où $T_f$ est la température de fusion du métal de ladite couche métallique (10) ;
   - on choisit la dose d'ions par unité de surface dans une plage comprise entre $10^{12}$ ions/cm$^2$ et $10^{18}$ ions/cm$^2$ de manière à fragmenter la couche métallique (10) pour produire des amas métalliques (40) sous forme de nanoparticules sur la surface du substrat, dont l'épaisseur maximale est comprise entre 0,2 nm et 20 nm et la largeur maximale est comprise entre 0,2 nm et 100 nm.

2. Procédé selon la revendication précédente **caractérisé en ce que** la dose d'ions par unité de surface est comprise entre $10^{14}$ ions/cm$^2$ et $10^{17}$ ions/cm$^2$.

3. Procédé selon l'une quelconque des revendications précédentes **caractérisé en ce que** l'épaisseur de la couche métallique (10), $e_{frag}$, est comprise entre 1 nm et 10 nm.

4. Procédé selon l'une quelconque des revendications précédentes **caractérisé en ce qu'**il comprend en outre une étape (aa) de pulvérisation de couche métallique, préalable à l'étape (a) de fragmentation de couche métallique, consistant à réduire l'épaisseur initiale, $e_{pulv} + e_{frag}$, d'une couche métallique (20, 10) déposée sur le substrat (20) par bombardement ionique jusqu'à ce que ladite couche atteigne l'épaisseur $e_{frag}$.

5. Procédé selon la revendication précédente en ce que la tension d'accélération des ions de l'étape (aa) de pulvérisation de couche métallique est comprise entre 5 kV et 20 kV.

6. Procédé selon l'une quelconque des revendications précédentes **caractérisé en ce que** le substrat (30) et la couche métallique (10, 20) sont mobiles par rapport au faisceau d'ions (100) à une vitesse, $V_D$, comprise entre 0,1 mm/s et 1000 mm/s et où une même zone de la couche métallique (10, 20) peut être déplacée sous le faisceau d'ions (100) selon une pluralité, N, de passages à la vitesse $V_D$.

7. Procédé selon l'une quelconque des revendications précédentes **caractérisé en ce que** l'étape du choix de la dose d'ions par unité de surface de manière à fragmenter la couche métallique (10) pour produire des amas métalliques (40) est effectuée en utilisant des données préalablement établies permettant de représenter l'évolution du taux de couverture d'une couche métallique en fonction de la dose d'ions par unité de surface.

8. Procédé selon la revendication précédente **caractérisé en ce que** les données permettant de représenter l'évolution du taux de couverture sont basées sur des mesures expérimentales du taux de couverture d'une couche métallique obtenues par spectroscopie de photo électrons X (XPS).

9. Procédé selon l'une quelconque des revendications précédentes **caractérisé en ce que** la couche métallique (10, 20) est constituée d'un métal ou d'un alliage de ce métal, où le métal est choisi parmi la liste constituée du fer (Fe), du cobalt (Co), du nickel (Ni), du cuivre (Cu), du ruthénium (Ru), du rhodium (Rh), du palladium (Pd), de l'argent (Ag), du cérium (Ce), de l'osmium (Os), de l'iridium (Ir), du platine (Pt), de l'or (Au).

**10.** Substrat (30) recouvert d'amas métalliques (40) sous forme de nano particules sur la surface du substrat dont l'épaisseur maximale est comprise entre 0,2 nm et 20 nm et la largeur maximale est comprise entre 0,2 nm et 100 nm, obtenu selon le procédé comprenant une étape de fragmentation d'une couche métallique selon l'une quelconque des revendications précédentes, où lesdits amas métalliques occupent entre 1% et 90% de la surface du substrat et où le substrat est dénudé sur respectivement 99% à 10% de sa surface, où ces amas sont présents sur la surface du substrat et sont séparés par des zones où ledit substrat est dépourvu de la matière de ladite couche.

**11.** Dispositif de catalyse hétérogène comprenant une zone de transformation d'un gaz ou d'un liquide comprenant au moins un substrat (30) recouvert d'amas métalliques (40) selon la revendication précédente.

## Patentansprüche

**1.** Verfahren zur Ionenstrahlbehandlung (100) einer auf einem Substrat (30) abgelagerten Metallschicht (10), **dadurch gekennzeichnet, dass** es einen Schritt (a) der Fragmentierung der Metallschicht umfasst, wobei man unter "Fragmentierung" ein Verfahren versteht, welches ermöglicht, eine Schicht aus einem Material so zu zerlegen, dass Haufen aus dem Material der Schicht erzeugt werden, die voneinander isoliert sind, wobei diese Haufen auf der Oberfläche des Substrats vorhanden sind und durch Zonen getrennt sind, wo das Substrat frei von dem Material der Schicht ist, und wobei:

- die Metallschicht (10) eine Dicke, $e_{frag}$, hat, die zwischen 0,2 nm bis 20 nm (Nanometer) beträgt;
- die Ionen des Ionenstrahls ausgewählt werden aus Ionen von Elementen der Liste bestehend aus Helium (He), Bor (B), Kohlenstoff (C), Stickstoff (N), Sauerstoff (O), Neon (Ne);
- die Spannung der Ionenbeschleunigung zwischen 20 kV und 200 kV beträgt;
- die Temperatur der Metallschicht (10) kleiner oder gleich $T_f/3$ ist, wobei $T_f$ die Schmelztemperatur des Metalls der Metallschicht (10) ist;
- man die Ionendosis pro Oberflächeneinheit in einem Bereich wählt, der zwischen $10^{12}$ Ionen/cm$^2$ und $10^{18}$ Ionen/cm$^2$ liegt, sodass die Metallschicht (10) fragmentiert wird, um Metallhaufen (40) in Form von Nanopartikeln auf der Substratoberfläche zu erzeugen, deren maximale Dicke zwischen 0,2 nm und 20 nm beträgt und deren maximale Breite zwischen 0,2 nm und 100 nm beträgt.

**2.** Verfahren nach dem vorstehenden Anspruch, **dadurch gekennzeichnet, dass** die Ionendosis pro Oberflächeneinheit zwischen $10^{14}$ Ionen/cm$^2$ und $10^{17}$ Ionen/cm$^2$ beträgt.

**3.** Verfahren nach einem der vorstehenden Ansprüche, **dadurch gekennzeichnet, dass** die Dicke der Metallschicht (10), $e_{frag}$, zwischen 1 nm und 10 nm beträgt.

**4.** Verfahren nach einem der vorstehenden Ansprüche, **dadurch gekennzeichnet, dass** es weiter einen Schritt (aa) der Pulverisierung der Metallschicht umfasst, der dem Schritt (a) der Fragmentierung der Metallschicht vorausgeht, darin bestehend, die ursprüngliche Dicke, $e_{pulv} + e_{frag}$, einer auf dem Substrat (20) abgelagerten Metallschicht (20, 10) durch Ionenbeschuss zu verringern, bis die Schicht die Dicke $e_{frag}$ erreicht.

**5.** Verfahren nach dem vorstehenden Anspruch, **dadurch gekennzeichnet, dass** die Spannung der Ionenbeschleunigung von Schritt (aa) zur Pulverisierung der Metallschicht zwischen 5 kV und 20 kV beträgt.

**6.** Verfahren nach einem der vorstehenden Ansprüche, **dadurch gekennzeichnet, dass** das Substrat (30) und die Metallschicht (10, 20) in Bezug auf den Ionenstrahl (100) mit einer Geschwindigkeit, $V_D$, beweglich sind, die zwischen 0,1 mm/s und 1000 mm/s beträgt, und wobei eine gleiche Zone der Metallschicht (10, 20) unter dem Ionenstrahl (100) gemäß einer Vielzahl, N, von Durchgängen mit der Geschwindigkeit $V_D$ verschoben werden kann.

**7.** Verfahren nach einem der vorstehenden Ansprüche, **dadurch gekennzeichnet, dass** der Schritt des Wählens der Ionendosis pro Oberflächeneinheit, um die Metallschicht (10) zum Erzeugen von Metallhaufen (40) zu fragmentieren, ausgeführt wird, indem zuvor erhobene Daten verwendet werden, die eine Darstellung des Verlaufs des Abdeckungsgrades einer Metallschicht in Abhängigkeit von der Ionendosis pro Oberflächeneinheit ermöglichen.

8. Verfahren nach dem vorstehenden Anspruch, **dadurch gekennzeichnet, dass** die Daten, die eine Darstellung des Verlaufs des Abdeckungsgrades ermöglichen, auf experimentellen Messungen des Abdeckungsgrades einer Metallschicht basieren, erhalten mittels Röntgenphotoelektronenspektroskopie (XPS).

9. Verfahren nach einem der vorstehenden Ansprüche, **dadurch gekennzeichnet, dass** die Metallschicht (10, 20) aus einem Metall oder einer Legierung dieses Metalls besteht, wobei das Metall gewählt wird aus der Liste bestehend aus Eisen (Fe), Kobalt (Co), Nickel (Ni), Kupfer (Cu), Ruthenium (Ru), Rhodium (Rh), Palladium (Pd), Silber (Ag), Cer (Ce), Osmium (Os), Iridium (Ir), Platin (Pt), Gold (Au).

10. Substrat (30), bedeckt von Metallhaufen (40) in Form von Nanopartikeln auf der Oberfläche des Substrats, deren maximale Dicke zwischen 0,2 nm und 20 nm beträgt und deren maximale Breite zwischen 0,2 nm und 100 nm beträgt, erhalten gemäß dem Verfahren, umfassend einen Schritt der Fragmentierung einer Metallschicht, nach einem der vorstehenden Ansprüche, wobei die Metallhaufen zwischen 1 % und 90 % der Oberfläche des Substrats belegen und wobei das Substrat auf jeweils 99 % bis 10 % seiner Oberfläche unbedeckt ist, wobei diese Haufen auf der Oberfläche des Substrats vorhanden sind und durch Zonen getrennt sind, wo das Substrat frei von dem Material der Schicht ist.

11. Vorrichtung zur heterogenen Katalyse, umfassend eine Zone zur Umwandlung eines Gases oder einer Flüssigkeit, umfassend mindestens ein von Metallhaufen (40) bedecktes Substrat (30) nach dem vorstehenden Anspruch.

## Claims

1. Method for the ion beam treatment (100) of a metal layer (10) deposited on a substrate (30) **characterized in that** it comprises a step (a) of fragmentation of said metal layer, by "fragmentation" is meant a method making it possible to divide a layer of a material so as to produce deposits of said material of the layer, isolated from each other, these deposits are present on the surface of the substrate and are separated by areas where said substrate is free from the material of the said layer and where:

   - the metal layer (10) has a thickness, $e_{frag}$, comprised between 0.2 nm to 20 nm (nanometre);
   - the ions of the ion beam are selected from the ions of the elements of the list constituted by helium (He), boron (B), carbon (C), nitrogen (N), oxygen (O), neon (Ne);
   - the ion acceleration voltage is comprised between 20 kV and 200 kV;
   - the temperature of the metal layer (10) is less than or equal to $T_f/3$, where $T_f$ is the melting temperature of the metal of said metal layer (10);
   - the ion dose per surface unit is chosen from a range comprised between $10^{12}$ ions/cm$^2$ and $10^{18}$ ions/cm$^2$ so as to fragment the metal layer (10) in order to produce metal deposits (40) in the form of nanoparticles on the surface of the substrate, the maximum thickness of which is comprised between 0.2 nm and 20 nm and the maximum width is comprised between 0.2 nm and 100 nm.

2. Method according to the previous claim **characterized in that** the ion dose per surface unit is comprised between $10^{14}$ ions/cm$^2$ and $10^{17}$ ions/cm$^2$.

3. Method according to any one of the previous claims **characterized in that** the thickness of the metal layer (10), $e_{frag}$, is comprised between 1 nm and 10 nm.

4. Method according to any one of the previous claims **characterized in that** it also comprises a step (aa) of pulverization of the metal layer, prior to the step (a) of fragmentation of the metal layer, consisting of reducing the initial thickness, $e_{pulv} + e_{frag}$, of a metal layer (20, 10) deposited on the substrate (20) by ionic bombardment until said layer reaches the thickness $e_{frag}$.

5. Method according to the previous claim **characterized in that** the ion acceleration voltage of the step (aa) of pulverization of the metal layer is comprised between 5 kV and 20 kV.

6. Method according to any one of the previous claims **characterized in that** the substrate (30) and the metal layer (10, 20) are mobile with respect to the ion beam (100) at a speed, $V_D$, comprised between 0.1 mm/s and 1000 mm/s and where the same area of the metal layer (10, 20) can be moved under the ion beam (100) in a plurality, N, of passes at speed $V_D$.

7. Method according to any one of the previous claims **characterized in that** the step of the choice of the ion dose per surface unit so as to fragment the metal layer (10) in order to produce metal deposits (40) is carried out using previously-established data making it possible to show the development of the coverage rate of a metal layer as a function of the ion dose per surface unit.

8. Method according to the previous claim **characterized in that** the data making it possible to show the development of the coverage rate are based on experimental measurements of the coverage rate of a metal layer obtained by X-ray photoelectron spectroscopy (XPS).

9. Method according to any one of the previous claims **characterized in that** the metal layer (10, 20) is constituted by a metal or an alloy of this metal, where the metal is chosen from the list constituted by iron (Fe), cobalt (Co), nickel (Ni), copper (Cu), ruthenium (Ru), rhodium (Rh), palladium (Pd), silver (Ag), cerium (Ce), osmium (Os), iridium (Ir), platinum (Pt) and gold (Au).

10. Substrate (30) covered with metal deposits (40) in the form of nanoparticles on the surface of the substrate, the maximum thickness of which is comprised between 0.2 nm and 20 nm and the maximum width is comprised between 0.2 nm and 100 nm, obtained according to the process comprising a step of fragmenting a metal layer according to any one of the preceding claims, where said metal deposits occupy between 1% and 90% of the surface of the substrate and where the substrate is exposed over 99% to 10% of its surface respectively, where these deposits are present on the surface of the substrate and are separated by areas where said substrate is free from the material of the layer.

11. Heterogeneous catalysis device comprising an area of conversion of a gas or of a liquid comprising at least one substrate (30) covered with metal deposits (40) according to the previous claim, in particular obtained with the method according to any one of claims 1 to 13.

**FIG. 1a**

**FIG. 1b**

FIG. 1c

FIG. 2a

500 nm

FIG. 2b

500 nm

FIG. 2c

500 nm

**FIG. 3**

**FIG. 4**

FIG. 5a

FIG. 5b

FIG. 6

FIG. 7

FIG. 8

FIG. 9

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **I.YAMADA.** Materials processing by gas cluster ion beams. *Mat.Sc.and Eng.,* 2001, vol. R.34, 231-295
- **J.K.G. PANTIZ.** Conical surface textures formed by ion bombarding 2%Be-Cu alloy. *J.Micromech. Micro-eng.,* 1991, vol. 1, 52-59

- **J.F. ZIEGLER.** The Stopping and Range of Ions in Matter. Pergamon Press, 1977, vol. 2-6
- **J.F. ZIEGLER ; J.P. BIERSACK ; U. LITTMARK.** The Stopping and Range of Ions in Solids. Pergamon Press, 1985
- **J.P. BIERSACK ; L. HAGGMARK.** *Nucl. Instr. and Meth.,* 1980, vol. 174, 257